(19) Europäisches Patentamt
European Patent Office
Office européen des brevets

(11) **EP 3 583 619 B1**

(12) **EUROPÄISCHE PATENTSCHRIFT**

(45) Veröffentlichungstag und Bekanntmachung des Hinweises auf die Patenterteilung:
**27.10.2021 Patentblatt 2021/43**

(21) Anmeldenummer: **18708602.0**

(22) Anmeldetag: **14.02.2018**

(51) Int Cl.:
*H01J 37/32* *(2006.01)*  *C23C 14/32* *(2006.01)*
*H01J 37/34* *(2006.01)*

(86) Internationale Anmeldenummer:
**PCT/EP2018/053724**

(87) Internationale Veröffentlichungsnummer:
**WO 2018/149894 (23.08.2018 Gazette 2018/34)**

(54) **LICHTBOGENKATHODENVERDAMPFUNG MIT VORBESTIMMTEM KATHODENMATERIALABTRAG**

CATHODIC ARC EVAPORATION WITH PREDETERMINED CATHODE MATERIAL REMOVAL

ÉVAPORATION PAR ARC CATHODIQUE AVEC ENLÈVEMENT DE MATIÈRE À LA CATHODE PRÉDÉFINI

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **14.02.2017 US 201762458631 P**

(43) Veröffentlichungstag der Anmeldung:
**25.12.2019 Patentblatt 2019/52**

(73) Patentinhaber: **Oerlikon Surface Solutions AG, Pfäffikon**
**8808 Pfäffikon SZ (CH)**

(72) Erfinder:
• **VETTER, Joerg**
**51429 Bergisch Gladbach (DE)**
• **WILLACH, Markus**
**51427 Bergisch Gladbach (DE)**

(74) Vertreter: **Misselhorn, Hein-Martin**
**Patent- und Rechtsanwalt**
**Am Stein 10**
**85049 Ingolstadt (DE)**

(56) Entgegenhaltungen:
EP-A1- 1 382 711    EP-A2- 0 508 612
WO-A1-89/01699     DE-A1- 10 127 012

**Beschreibung**

Die vorliegende Erfindung betrifft ein Verfahren zur Verdampfung einer Kathode mittels kathodischer Lichtbogenverdampfung, bei dem der Brennfleck des Lichtbogens zu einer vorbestimmten Laufbahn auf der Kathodenoberfläche mittels zeitlich und örtlich steuerbarer Magnetfelder gezwungen wird, wobei ein vorbestimmter Materialabtrag der Kathodenoberfläche produziert wird.

**Stand der Technik**

Bei Lichtbogenverdampfung (nachstehend auch Funkenverdampfung genannt, wobei Lichtbogenverdampfung = Funkenverdampfung, im Rahmen der vorliegenden Erfindung) von Materialien, welche als Kathode verwendet werden, bewegt sich der Brennfleck (auch Spot oder Kathodenbrennfleck genannt) meistens unberechenbar, wenn kein Magnetfeld verwendet wird. Insbesondere im Falle von Graphitmaterialien bewegt sich der Brennfleck äußerst willkürlich und langsam im Vergleich mit metallischen Materialien. In solchen Fällen passiert oft, dass der Spot sich an einem Ort der Oberfläche des zu verdampfenden Graphitmaterials so lange aufhält, dass ein tiefes Loch im Graphitmaterial entsteht und dabei der Lichtbogen verlischt.

Kandah et al beschreiben beispielweise in ihrem Artikel "Vaccum arc cathode spot movement on various kinds of graphite cathodes" in Plasma Sources Sci. Technol. 5 (1996) 349-355, wie ein Kathodenbrennfleck sich auf einer Graphitkathode im Vergleich mit einer Kathode aus metallischem Material langsamer bewegt, dass er sich sogar verankern und dabei im Graphitmaterial festbrennen kann. Im selben Artikel berichten Kandah et al, dass durch die Verwendung von starken Magnetfeldern, welche zeitlich und örtlich konstant gehalten werden, eine Reduzierung von Makropartikeln in Schichten, welche mittels Lichtbogenverdampfung von Graphitkathoden hergestellt werden, erreicht werden kann. Sie erklären, dass diese starken Magnetfelder eine Erhöhung der Geschwindigkeit des Brennflecks und mithin eine Verringerung der Einwirkzeit der Wärme des Brennflecks im Kathodenbrennfleckbereich herbeiführen, was eine reduzierte Generierung von Makropartikeln aus der Graphitkathode zur Folge hat. Für die durchgeführten Experimente haben Kandah et al die mittlere Spotgeschwindigkeit berechnet als die Spotlaufstrecke geteilt durch die Lichtbogendauer. Ein äußeres, stationäres Magnetfeld, parallel zur Kathodenoberfläche, wurde verwendet, um den Spot auf der Graphitkathodenoberfläche rückläufig zu bewegen, wie es typisch von Lichtbogen im Vakuum ist, welche unter dem Einfluss von transversalen Magnetfeldern sind. Es wurde beobachtet, dass sich der Spot auf unterschiedlichen Graphittypen stark unterschiedlich verhält, sowohl bezüglich der Spotgeschwindigkeit als auch bezüglich des Abtragsprofiles.

Nachstehend werden Magnetfelder, welche zeitlich und örtlich konstant gehalten werden, auch als "zeitlich und örtlich stationäre Magnetfelder" oder einfach als "stationäre Magnetfelder" bezeichnet.

Eine Einstellung eines optimalen Abtragsprofiles unter Verwendung eines solchen stationären Magnetfeldes stellt sich jedoch auf größer flächigen Kathoden als nahezu unmöglich dar. In diesem Zusammenhang sind beispielsweise bereits kreisförmige aktive Kathodenflächen betroffen, die einen Durchmesser von einigen Zentimetern, d.h. 2 cm oder mehr haben.

Auch andere Autoren haben in der letzten Zeit über Methoden zur Kontrolle der Bewegung des Kathodenbrennflecks auf Graphitkathoden unter Verwendung von Magnetfeldern berichtet.

Liuhe Li et al berichten beispielsweise in ihrem Artikel "Control of cathodic arc spot motion under external magnetic field" in Vacuum 91 (2013) 20-23 über den Einfluss von verschiedenen Stärken zeitlich und örtlich stationärer Magnetfelder, Lichtbogenstrom, Gasdruck und Oberflächenmorphologie auf die Bewegung und Dynamik des Kathodenbrennflecks auf rechteckförmigen Graphitkathoden. Das angewendete Magnetfeld wird durch eine Kombination von Permanentmagneten und elektromagnetischen Spulen generiert. Dieses zeitlich und örtlich stationäre Magnetfeld wirkt jedoch so weitgehend auf eine Laufspur, dass es zu einem ungleichmäßigen Materialabtrag der Graphitkathode führt.

In diesem Kontext berichten auch Aksenov et al in ihrem Artikel "Magnetic Field influence on the shape of eroding surface of graphite cathodes", in Problems of Atomic Science and Technology. 2002. Nr. 5 Series: Plasma Physics (8). P. 142-144, über den Einfluss von zeitlich und örtlich stationären Magnetfeldern auf die Form der abgetragenen Oberfläche einer Graphitkathode während der Funkenverdampfung. In diesem Zusammenhang wurden insbesondere Experimente durchgeführt, um die Wirkung des Gasdrucks und des Lichtbogenstroms zu untersuchen. Aksenov et al erwähnen außerdem, dass die Geschwindigkeit der Bewegung eines Kathodenflecks auf Graphit eine etwa 2 bis 3 geringere Größenordnung als auf Metall aufweist. Im Randbereich der Kathoden war trotz der Optimierung der Magnetfelder ein undefiniertes Abtragen (auch Erodieren genannt) des Kathodenmaterials festzustellen.

Die Verwendung von mehreren stationären Magnetfeldern, um einen Lichtbogen auf einer metallischen Kathode zur Bewegung zu zwingen, ist auch aus dem Stand der Technik bekannt. In diesem Zusammenhang beschreibt beispielsweise Vetter in DE4008850A1, dass durch das gezielte Umschalten von Randmagnetfeldern ein Herunterlaufen des Lichtbogens von der zu verdampfenden Kathodenoberfläche verhindert werden kann. Aus EP1382711 A1, WO 89/01699 A1 und EP0508612 A2 sind Vorrichtungen und Verfahren bekannt, den Spot auf unterschiedlichen Bahnen und/oder mit variabler Geschwindigkeit auf der Kathodenfläche mittels veränderbaren Magnetfeldern zu bewegen.

Die Erfinder haben jedoch festgestellt, dass diese bisherigen Lösungen, welche die Steuerung externer Magnetfelder umfassen, bisher nur eine beschränkt gezielte Einstellung der Abtragsprofile (auch Erosionsprofile genannt) ermöglichen.

**Aufgabe der vorliegenden Erfindung**

Der vorliegenden Erfindung liegt die Aufgabe zugrunde, ein Verfahren zur Verdampfung einer Kathode mittels kathodischer Lichtbogenverdampfung bereitzustellen, bei dem ein vorbestimmter Materialabtrag der Kathodenoberfläche produziert wird, insbesondere im Falle von zu verdampfenden Graphitkathodenmaterialien.

**Lösung der Aufgabe gemäß der vorliegenden Erfindung - Beschreibung der vorliegenden Erfindung**

Die Erfinder haben herausgestellt, dass sich überraschenderweise die oben genannten Nachteile der bisherigen Lösungen gemäß dem Stand der Technik bei der Lichtbogenverdampfung, insbesondere von Graphitmaterialien, mit zeitlich und örtlich steuerbaren Magnetfeldern ideal überwinden lassen, wobei die Erosion (nachstehend auch Abtrag genannt, wobei Erosion = Abtrag, im Rahmen der vorliegenden Erfindung) des Kathodenmaterials mit Hilfe der zeitlich und örtlich steuerbaren Magnetfelder gezielt eingestellt wird.

**Nähere Beschreibung der vorliegenden Erfindung**

Im Rahmen der vorliegenden Erfindung wird mit dem Ausdruck "zeitlich und örtlich steuerbares Magnetfeld" ein solches Magnetfeld bezeichnet, das Magnetfeldlinien aufweist, deren Eigenschaften zumindest während eines Teils der Einsetzungsdauer des Magnetfeldes in einem oder mehreren Orten gezielt verändert werden können.

Ebenfalls im Rahmen der vorliegenden Erfindung wird mit dem Ausdruck "stationäres Magnetfeld" ein solches, insbesondere externes, Magnetfeld bezeichnet, das Magnetfeldlinien aufweist, deren Eigenschaften während der Einsetzungsdauer des Magnetfeldes nicht zeitlich und örtlich steuerbar sind, d.h. es ist nicht möglich, während der Lichtbogenverdampfung die Laufbahn des Brennflecks dergestalt zu verändern, dass der Kathodenort, in dem Erosion auftritt, sich durch eine Änderung der Eigenschaften der Magnetfeldlinien zeitlich verändert lässt.

Nachstehend wird die Erfindung anhand von einigen Abbildungen und Ausführungsbeispielen näher erläutert:

**Abbildungen:**

- Abbildung 1: Darstellung von zwei in erfinderischer Weise eingestellten tunnelförmigen Magnetfeldern (in Abb. 1 als M1 und M2 bezeichnet) und der dadurch resultierenden Erosionswege (in Abb.1 als W1 und W2 bezeichnet) auf einer Kathode 30, wobei die Erosionswege jeweils kreisförmig mit entsprechenden Durchmessern (in Abb. 1 als D1 und D2 bezeichnet) aufgezeigt sind.
- Abbildung 2: Vorrichtung zur Durchführung eines erfinderischen Verfahrens.
- Abbildung 3: Darstellung der Erosionswege und erodierten Bereiche, welche durch die Verwendung eines erfinderischen Verfahrens gemäß dem untenstehenden Beispiel 2 resultieren.

Wird beispielweise ein Graphittarget (nachstehend auch einfach Target genannt), mit einer gegebenen Graphitqualität, als Kathode in einer Vakuumbeschichtungskammer betrieben, um das Graphittarget mittels Funkenverdampfung zu verdampfen, und dabei eine Kohlenstoffschicht auf eine Oberfläche eines in der Vakuumbeschichtungskammer gestellten Substrates abzuscheiden, kann man erfindungsgemäss zeitlich und örtlich steuerbare, tunnelförmige Führungsmagnetfelder einstellen, um beispielsweise unter Annahme einer konstanten Abtragsrate R für die gegebene Graphitqualität zeitlich integral die gleiche Menge von Amperesekunden an unterschiedlichen Orten des Targets (nachstehend auch einfach als Kathode bezeichnet) einzuspeisen.

In diesem Zusammenhang wird zur Bezeichnung der Abtragsrate des Graphitmaterials in Mikrogramm/Amperesekunde ($\mu$g/As) das Zeichen "$R_{Graph}$" verwendet.

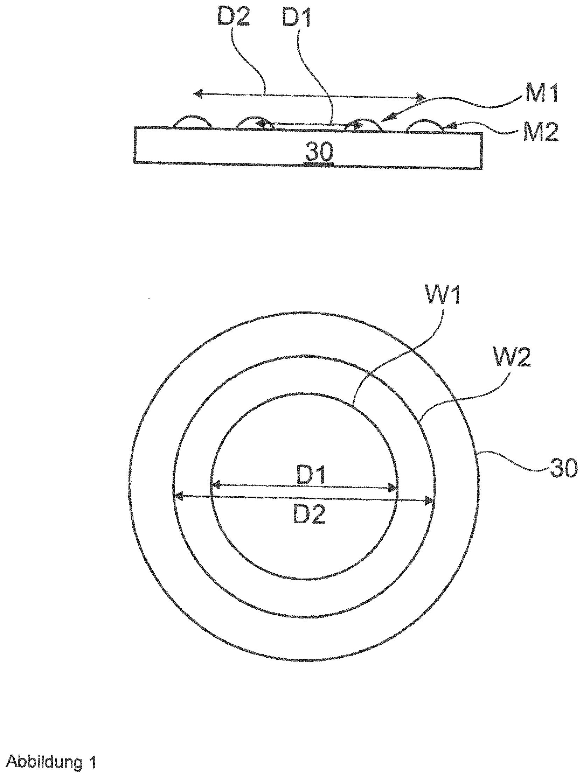

Die Erfindung wird nun anhand von Abbildung 1 erläutert, in der zwei erfindungsgemäss eingestellte Führungsmagnetfelder (M1 und M2) dargestellt sind.

Gemäß der vorliegenden Erfindung wird ein erstes geeignetes Führungsmagnetfeld M1 eingestellt, um einen ersten Bereich der Kathodenoberfläche zu erodieren. Dabei entsteht ein erster Erosionsweg W1. Der erste Erosionsweg W1 entspricht dann der Laufbahn des Brennflecks, wenn das erste Führungsmagnetfeld M1 erzeugt wird und eingestellt bleibt.

Der erste Erosionsweg W1 und die erste integrale Geschwindigkeit $\nu1$ des Spots, welche bei diesem ersten Führungsmagnetfeld M1 resultieren, werden mit geeigneten Methoden gemessen, z.B. durch visuelle Betrachtung.

Ebenfalls wird mindestens ein zweites Führungsmagnetfeld M2 eingestellt, welches zur Erosion eines zweiten Bereichs der Kathodenoberfläche führt. Dabei entsteht ein zweiter Erosionsweg W2, welcher der Laufbahn des Brennflecks entspricht, wenn das zweite Führungsmagnetfeld M2 erzeugt wird und eingestellt bleibt. Die zweite integrale Geschwindigkeit $v2$ und der zweite Erosionsweg, die bei diesem zweiten Führungsmagnetfeld M2 resultieren, werden ebenfalls gemessen.

Wenn der erste Erosionsweg W1 eine erste Länge L1 und der zweite Erosionsweg W2 eine zweite Länge L2 haben, und es gilt L2 > L1, muss dann, unter Annahme der gleichen integralen Spotgeschwindigkeit für beide Erosionswege ($v1 = v2$), die Zeit t2 für einen Umlauf des zweiten Erosionswegs W2 im Vergleich mit der Zeit t1 für einen Umlauf des ersten Erosionswegs größer sein, d.h. t2 > t1.

Somit ergibt sich Folgendes:

$v1 = L1/t1 = v2 = L2/t2$ für dasselbe Targetmaterial unter Annahme einer gleichen, gegebenen Qualität des Targetmaterials,

d.h. $vi\text{-}1 = Li\text{-}1/ti\text{-}1 = vi = Li/ti$, und wobei i = 1 bis n, mit $n \geq 2$ und wobei i eine ganze Zahl ist und ebenfalls n eine ganze Zahl ist.

Die Erosion E wird für die jeweiligen Bereiche als E = R*t definiert, wobei Ei = R*ti und wenn i=n, dann En = R*tn = $E_{n-1}$ = R*$t_{n-1}$ ... unter Annahme einer konstanten Abtragsrate R.

## Erfinderisches Beispiel 1

Der am Lichtbogenverdampfer angelegte Strom in diesem Beispiel betrug 100 A, die gemessene Aufenthaltszeit des Spots im ersten Bereich war t1 = 40 s und die gemessene Erosionsrate war R1 = 18 $\mu$g/As, wobei R1 = R, wenn eine konstante Abtragsrate angenommen wird.

Darauffolgend kann die Erosion E1 im ersten Bereich wie folgt berechnet werden:

$$E1 = R*t1 = R1*t1 = 18 \text{ µg/As} * 100 \text{ A}*40 \text{ s} = 72000 \text{ µg}$$

Die Magnetmittel zur Erzeugung der Führungsmagnetfelder im angegebenen Beispiel wurden so eingestellt, dass kreisförmige oder nahezu kreisförmige Erosionswege entstanden. Der Durchmesser D1 des ersten Erosionswegs betrug ca. 8 cm. Aufgrund der kreisförmigen Form der Laufbahn des Spots wurde die Länge L1 der ersten Laufbahn des Brennflecks wie folgt berechnet:

$$L1 = \pi*D1 \approx 25 \text{ cm}$$

Daraus ergibt sich einerseits eine integrale Spotgeschwindigkeit $v1 = L1/t1$ von ca. 38 cm/min sowie eine auf den Erosionsweg bezogene spezifische Erosion Esp1=E1/L1 (Erosion geteilt durch Erosionsweg) von 2880 $\mu$g/cm.

Wenn die integrale Spotgeschwindigkeit in erster Nähe als konstant angenommen wird, dann gilt, dass bei einem Führungsfeld M1, das einen kreisförmigen Erosionsweg mit einem kleineren Durchmesser D1 erzeugt, dass die Laufzeit kürzer sein muss, wenn die gleiche spezifische Erosion eingestellt werden soll. Beispielsweise bei einem anderen Erosionsweg mit einem halben Durchmesser im Vergleich mit dem oben erwähnten Beispiel, dann hätte man einen Durchmesser D1 = 4 cm (anstatt D1 = 8 cm, wie oben angegeben) und dadurch würde sich eine Laufzeit (Zeit zur Durchlauf der Laufbahn einmal) von t1 ca. 19 s ergeben.

In einer weiteren Ausführungsform der Erfindung kann ein Verfahren so durchgeführt werden, dass mehrere Magnetfelder Mi mit i=1 bis n erzeugt werden, wobei die jeweilige exakte Laufzeit ti für jedes eingestellte Führungsmagnetfeld Mi wie oben beschrieben berechnet und eingestellt wird.

Diese lineare Betrachtungsweise ermöglichte die Einstellung von mehreren Erosionswegen Wi und auf diese Weise konnten überraschenderweise sehr gute Erosionsergebnisse erzielt werden. Mit anderen Worten, eine erstaunlich homogene Erosion der Kathodenoberfläche wurde erreicht. Dieses erfinderische Verfahren hat außerdem überraschenderweise ermöglicht, die Anzahl von Droplets in den dabei hergestellten Kohlenstoffschichten deutlich zu reduzieren.

Zur Durchführung eines erfinderischen Verfahrens (wie das beispielsweise oben beschriebene erfinderische Verfahren) muss aber auch eine geeignete Vorrichtung angewendet werden.

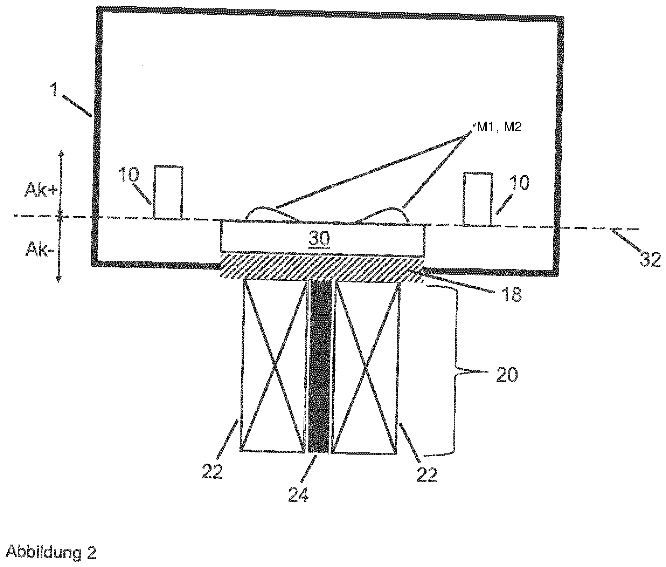

Eine solche geeignete Vorrichtung wird in Abbildung 2 gezeigt. Die Vorrichtung umfasst einen Lichtbogenverdampfer (30,10,18, 20) mit inneren Magnetmitteln 10, die sich im Inneren der Vakuumbeschichtungskammer 1 befinden und zur Erzeugung eines inneren Magnetfelds verwendet werden, wobei die inneren Magnetmittel 10 die Kathode 30 umgeben. Zur Erzeugung eines äußeren Magnetfeldes befindet sich hinter der Kathode 30, außerhalb der Vakuumbeschichtungskammer 1, ein äußeres Magnetmittel 20. Das äußere Magnetmittel besteht in diesem Beispiel aus einer Spule 22 und einem Kern 24. Der Kern 24 kann aus einem ferritischen Material oder aus einem geeigneten permanentmagnetischen Material bestehen. Die Erosionsorte in den verschiedenen Bereichen der Kathodenfläche können dann mit dieser Vorrichtung, unter Berücksichtigung der integralen Laufgeschwindigkeit des Spots, in Sekunden bis Minuten eingestellt werden.

Vetter beschreibt in EP2140476B1 einen Lichtbogenverdampfer, der innere Ringmagnete und äußere Ringmagnete aufweist, welche die Einstellung eines in axialer Richtung verstellbaren, äußeren Permanentmagnetfeldes ermöglichen, wobei die inneren Ringmagnete um die Kathode angeordnet sind. Dieses Permanentmagnetfeld ist jedoch ein stationäres Magnetfeld, welches während der Abscheidung einer Schicht mittels Lichtbogenverdampfens der Kathode nicht zeitlich und örtlich veränderbar ist und deshalb zu einer ungeeigneten Steuerung der Kathodenverdampfung gewisser Kathodenmaterialien führen würde. Ein solches stationäres Magnetfeld ist insbesondere ungeeignet für Graphitverdampfung, wenn eine gleichmäßige Erosion der Kathodenoberfläche zu erreichen ist, und ebenfalls wenn ein Festbrennen des Kathodenbrennfleckes an einem Ort der Kathodenfläche vermieden werden soll.

Gemäß einer Ausführungsform der vorliegenden Erfindung wird der oben erwähnte Verdampfer modifiziert und erfindungsgemäß derart konfiguriert, dass anstelle der äußeren Ringmagnete zumindest eine geeignete Spule 22, vorzugsweise mit Eisenkern 24, verwendet wird, um eine zeitliche und örtliche Einstellung der Erosionsfläche in einfacher Weise zu steuern. Auf diese Weise kann die Einstellung der Erosionsflächen gesteuert werden, indem beispielsweise für die Einstellung einer ersten Erosionsfläche in einem ausgewählten Bereich der Kathodenfläche eine erste definierte, zeitlich konstante Stromeinspeisung (in Ampere) der Spule 22 eingestellt wird, und für die Einstellung einer weiteren Erosionsfläche in einem anderen Bereich der Kathodenfläche eine andere definierte, zeitlich konstante Stromeinspeisung der Spule 22 eingestellt wird. Durch die Einstellung der Dauer einer definierten, konstanten Stromeinspeisung der Spule 22 kann die Dauer der Aufenthaltszeit (in Sekunden bis Minuten) des Kathodenbrennflecks in der jeweiligen Erosionsfläche definiert werden. Somit kann dann die Erosion in jedem jeweils ausgewählten Bereich der Kathodenfläche gesteuert werden.

Gemäß einer bevorzugten Ausführungsform der vorliegenden Erfindung wird für die Einstellung der lokalen Erosion in den jeweiligen Bereichen der Kathodenfläche das oben beschriebene Verfahren verwendet, wobei das Verfahren folgenden Schritt umfasst:

Erzeugung eines inneren Magnetfelds, das vorzugsweise, aber nicht ausschließlich, mit Permanentmagneten erzeugt und um die Kathode kreisförmig angeordnet wird, wobei die relative Lage sich in der Kathodenebene 32, aber auch in einem gewissen Abstand Ak+ vor der Kathodenebene, oder in einem gewissen Abstand Ak- unterhalb der Kathodenebene befinden kann (siehe beispielsweise die Darstellung des Abstands Ak+ und Ak- in Abbildung 2). Beispielsweise bis zu 10 mm oberhalb oder bis zu einem Abstand nicht grösser als 70% der Magnetlänge unterhalb der Kathode. Vorzugsweise erzeugt dieses innere Magnetfeld weitgehend senkrechte Magnetfeldlinien auf der Kathodenoberfläche, deren Dichte zum Kathodenrand hin zunimmt.

Dieses innere Magnetfeld wird vorzugsweise so erzeugt, dass es das Laufverhalten im Wesentlichen in die Mitte der Kathode konzentriert.

Zwischen der Kathode 30 und den äußeren Magnetmitteln 20 ist eine Kathodenaufnahmeplatte 18, die beispielsweise eine Kühlungsfunktion aufweist und eine Stromzuführung umfasst.

Das innere Magnetfeld und die magnetische Polarisation der Spule werden vorzugsweise so eingestellt, dass auf der Kathodenoberfläche ein Führungsmagnetfeld entsteht, welches vorzugsweise ein tunnelförmiges Führungsmagnetfeld ist, das zeitlich und örtlich steuerbar ist. Für kreisförmige Kathoden wird dabei der Laufradius des Lichtbogens (auch Laufradius des Funkens oder des Spots genannt) verändert. Im Falle eines inneren Magnetfeldes, das die Kathode umschließt und aus Permanentmagneten besteht, werden die in Richtung der Kathode gezeigten Pole und die Polarisation der Spule gegenpolig ausgelegt. Ist das Feld des inneren Magnetsystems in Richtung der Kathode der Nordpol, dann wird die Spule so polarisiert, dass deren Südpol in Richtung der Kathode zeigt, oder eben umgekehrt. Auf diese Weise kann ein tunnelförmiges Führungsmagnetfeld entstehen.

Zur Durchführung des oben beschriebenen Beispiels 1 wurde eine scheibenförmige Graphitkathode mit kreisförmiger zu verdampfender Fläche verwendet, die einen Durchmesser von 100 mm und eine Dicke von 15 mm aufwies.

Die vorliegende Erfindung kann aber auch unter Beachtung der spezifischen geometrischen Gegebenheiten für andere Formen von zu verdampfenden Kathodenflächen verwendet werden. Beispielsweise können elliptische, rechteckige, und sonstige Formen von zu verdampfenden Kathodenflächen verwendet werden. Gegebenenfalls sind jedoch Einschränkungen der Kathodenausnutzung gegeben.

Vorzugsweise werden zu verdampfende Kathoden mit kreisförmigen zu verdampfenden Flächen verwendet.

Gemäß einer weiteren bevorzugten Ausführungsform der vorliegenden Erfindung kann die oben beschriebene, modifizierte Vorrichtung verwendet werden, um ein erfinderisches Verfahren durchzuführen, wobei das Führungsmagnetfeld durch die äußere Spule verändert wird, um ein tunnelförmiges Führungsmagnetfeld M anzulegen. Die zeitliche Veränderung des Magnetfeldes durch die Einstellung der Spule wird in diesem Zusammenhang, wie bereits oben erwähnt, vorzugsweise durch eine Änderung der Stromstärke (Stromspeisung) der Spule gemacht. Die zu wählende Stromstärke ist beispielsweise von der Anzahl der Wicklungen und der Art des Kernes 24 abhängig.

Das oben erwähnte tunnelförmige Führungsmagnetfeld kann dann durch das Betreiben der Spule mit verschiedenen Strömen so eingestellt werden, dass verschiedene Führungsmagnetfelder bzw. eine Anzahl n von Führungsmagnetfeldern Mi mit i = 1 bis n (i ist eine ganze Zahl und n ist auch eine ganze Zahl und n ist $\geq$ 2) erzeugt werden, wobei jedes Führungsmagnetfeld Mi den Brennfleck des Lichtbogens auf eine jeweilige Laufbahn zur Entstehung eines entsprechenden Erosionswegs Wi führt.

Diese Laufbahnen des Spots oder Erosionswege können beispielsweise konzentrisch und kreisförmig in Bezug mit der Kathodenoberfläche generiert werden.

Wenn der jeweilige Erosionsweg Wi kreisförmig ist und in der Mitte der Kathodenfläche zentriert ist, dann sollen die Erosionswege jeweils einen unterschiedlichen Durchmesser Di aufweisen, beispielsweise wenn n = 4, dann D1 > D2 > D3 > D4.

Ein tunnelförmiges Führungsmagnetfeld ist exemplarisch in den Abbildungen 1 und 2 gezeigt.

**Beispiel 2:**

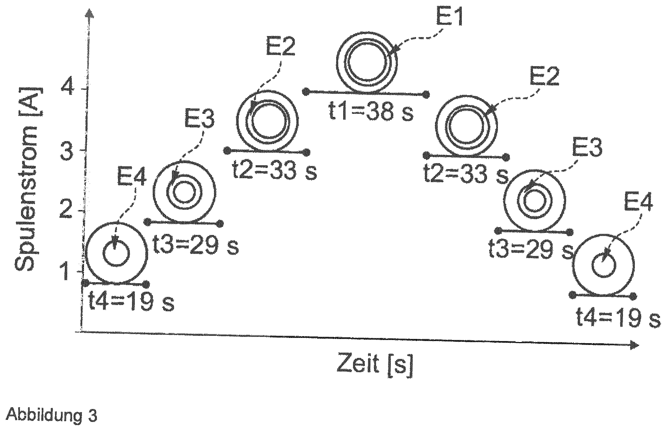

Folgende Parameter wurden zur Durchführung des Beispiels 2 verwendet, siehe auch Abbildung 3.

- Bogenstrom 70 A
- Graphitkathode mit 100 mm Durchmesser
- Der maximale Spulenstrom wurde so gewählt, dass ein Laufen des Lichtbogens über den Kathodenrand verhindert wird.
- Zur Einstellung eines ersten Führungsmagnetfelds M1 wurde ein Spulenstrom von 4 A eingestellt und ein Durchmesser D1 = 8 cm gemessen, und die entsprechende Zeitdauer und von t1 = 38 s gemessen, siehe Beispiel 1.
- Zur Einstellung eines zweiten Führungsmagnetfelds M2 wurde ein Spulenstrom von 3 A eingestellt und ein Durchmesser D2 = 7 cm gemessen, und die erfindungsgemäße entsprechende Zeitdauer von t2 = 33 s berechnet.
- Zur Einstellung eines dritten Führungsmagnetfelds M3 wurde ein Spulenstrom von 2 A eingestellt und ein Durchmesser D3 = 6 cm gemessen, und die erfindungsgemäße entsprechende Zeitdauer von t3 = 29 s berechnet.
- Zur Einstellung eines vierten Führungsmagnetfelds M4 wurde ein Spulenstrom von 1 A eingestellt und ein Durchmesser D4 = 4 cm gemessen, und die erfindungsgemäße entsprechende Zeitdauer von t4 = 19 s berechnet.

Die Schaltung des Spulenstroms zur Generierung der Führungsmagnetfelder M1 bis M4 kann beispielsweise zeitlich integral mit gleicher Häufigkeit ausgeführt werden (z.B. sequenziell eins nach dem anderem, d.h. zuerst M1 während einer ersten Zeit t1, danach M2 während einer zweiten Zeit t2, danach M3 während einer dritten Zeit t3, danach M4 während einer Zeit t4, danach wieder M1 während einer Zeit 1 und so weiter).

Es wurde getestet, was mit der Bewegung des Brennflecks des Lichtbogens passiert, wenn ein Spulenstrom von 0 A verwendet wird, d.h. kein tunnelförmiges Führungsmagnetfeld erzeugt wird. Es wurde beobachtet, dass der Lichtbogen nur stochastisch in der Mitte der Kathode laufen konnte und die Gefahr des lokalen Festbrennens besteht. Es wurde festgestellt, dass kurzzeitig, in der Regel im Bereich einiger 10 s, dieses nicht tunnelförmige Magnetfeld innerhalb einer sequenziellen Schaltung der Führungsmagnetfelder M1 bis M4 vorteilhaft sein kann, z.B. im Zündvorgang des Lichtbogens.

Die Schaltung kann auch derart ausgeführt werden, dass Vielfache der Zeit ti mit ti = 1 bis n gesteuert werden, beispielsweise Faktor 2, wobei dies im zeitlichen Integral stattfinden muss. Das Verfahren kann dann beispielsweise wie folgt ausgeführt werden:
M1 während t1, gefolgt von M2 während t2, gefolgt von M3 während t3, gefolgt von M4 während 2xt4, gefolgt von M3 während t3, gefolgt von M1 während t1, gefolgt von M2 während t2 und so weiter. Dadurch werden alle Erosionswege im zeitlichen Mittel gleich häufig durchlaufen.

Diese Beispiele sollen aber keinesfalls als Einschränkungen des erfinderischen Verfahrens angesehen werden. Die sequenzielle Schaltung der Führungsmagnetfelder kann der Fachmann nach Bedarf, unter Berücksichtigung der gewünschten Erosionsprofile auf der Kathodenfläche anpassen.

Die Erfinder haben festgestellt, dass es vorteilhaft ist, wenn der Abstand A zwischen zwei benachbarten Laufbahnen mindestens 1 mm beträgt, vorzugsweise aber 3 bis 10 mm beträgt.

Neben der oben beschriebenen erfinderischen Lösung zur Einstellung von zeitlich und örtlichen Erosionsprofilen im definierten Bereich, wobei sich die jeweilige Zeit in Sekunden bis Minuten aus den gemessenen integralen Geschwindigkeiten des Funkens sowie der zu erodierenden Strecke ergibt, können auch andere Lösungen zum Aufbau des geeigneten tunnelförmigen Führungsmagnetfeldes eingesetzt werden.

Es ist aber wesentlich für die Erfindung, dass ein tunnelförmiges Führungsmagnetfeld entsteht, wobei zu dessen Erzeugung dem Fachmann bekannte geeignete Magnetmittel mit auch dem Fachmann bekannter, geeigneter Polarisierung verwendet werden können.

Beispielsweise kann eine innere und eine äußere Spule oder mehrere Permanentmagnete oder eine Kombination von Spulen und Permanentmagneten verwendet werden.

Abbildung 2 zeigt als Beispiel eine Anordnung mit inneren Magnetmitteln (innerhalb der Vakuumkammer, wo sich die zu verdampfende Kathodenfläche befindet) und äußeren Magnetmitteln (hinter der Kathode) zur Erzeugung eines inneren Magnetfeldes und eines äußeren Magnetfeldes, wobei durch die Wechselwirkung dieser Magnetfelder ein tunnelförmiges Führungsmagnetfeld entsteht, welches zeitlich und örtlich veränderbar ist.

Im Rahmen der vorliegenden Erfindung wurden mehrere Versuche durchgeführt, bei denen zur Lichtbogenverdampfung Graphitkathoden (auch Graphittargets genannt) mit verschiedenen Graphitqualitäten und Dichten im Bereich von 1.6 bis 1.9 g/cm3 eingesetzt wurden.

Die Lichtbogenentladung (auch Funkenentladung genannt) wurde mittels eines mechanischen Triggers gestartet. Jedoch auch andere Arten von Zündvorrichtungen können verwendet werden, beispielsweise elektrische oder mit Laser. Die Magnetfeldstärken wurden je nach gewünschtem Laufbereich der Funkenentladung gewählt. Typischerweise wurden Magnetfeldstärken so ausgewählt, dass die senkrechten Magnetfeldstärken des steuerbaren, tunnelförmigen Magnetfeldes im Bereich von 0,5 bis 30 mT betrugen. Die Prozesse wurden sowohl im Vakuum als auch unter Einsatz des Prozessgases Ar sowie unter Zuführung von Reaktivgasen, $O_2$, $N_2$, $C_2H_2$ und/oder $H_2$ stabil ausgeführt. Typischerweise betrugen die eingestellten Partialdrücke der Reaktivgase 0.1 bis 1 Pa. Die maximalen Prozessdrücke bei Ar betrugen 5 Pa. Bei allen Prozessbedingungen konnte eine ausgezeichnete Steuerung der Erosion erreicht werden.

Bei Lichtbogenverdampfung von Graphitkathoden mittels dieser gesteuerten Graphitverdampfung gemäß der vorliegenden Erfindung wurden sowohl graphitische Schichten als auch harte amorphe Schichten (DLC-Schichten) der Typen a-C, ta-C, a-C:H und a-C:N abgeschieden, wobei die härtesten Schichten (ta-C) bei geeigneten Prozessbedingungen der Schichtabscheidung Härten bis zu 80 Gpa aufwiesen.

Neben für Lichtbogenverdampfung von reinen Graphitkathoden ist dieses erfindungsgemäße Verfahren auch für Lichtbogenverdampfung von legierten Graphitkathoden anwendbar. Beispielweise von legierten Graphitkathoden, welche mindestens ein Legierungselement aufweisen, wobei vorzugsweise das mindestens eine Legierungselement eins von den folgenden Elementen: Si, B, F, Ti, Cr, Mo, W, Al und Cu ist. Das erfindungsgemässe Verfahren kann aber auch für Funkenverdampfung von Kathoden aus anderen Materialien, wie beispielsweise Kupfer, verwendet werden.

Wenn legierte Graphitkathoden verwendet werden, soll die Graphitkathode vorzugsweise das Legierungselement oder die Summe der Legierungselemente so umfassen, dass die Konzentration der Legierungselemente in Atomprozent in einem Bereich von 0,1 bis 49 at%, vorzugsweise von 1 bis 25 at%, liegt.

Die vorliegende Erfindung offenbart konkret:

Ein Verfahren zur Verdampfung einer Kathode mittels eines kathodischen Lichtbogenverdampfungsprozesses in einer Vakuumkammer, bei dem ein Lichtbogen gezündet wird und die Bewegung des Brennflecks des Lichtbogens auf einer vorbestimmten Laufbahn auf der zu verdampfenden Kathodenoberfläche mittels eines Führungsmagnetfeldes gezwungen wird, wobei innere Magnetmittel innerhalb der Vakuumkammer und äußere Magnetmittel außerhalb der Vakuumkammer zur Erzeugung mindestens jeweils eines inneren Magnetfeldes und eines äußeren Magnetfeldes verwendet werden, wobei das Führungsmagnetfeld ein tunnelförmiges Führungsmagnetfeld ist, welches durch die Wechselwirkung der Magnetfelder entsteht, dadurch gekennzeichnet, dass das tunnelförmige Führungsmagnetfeld veränderbar ist und während der Durchführung des Lichtbogenverdampfungsprozesses mindestens zwei unterschiedliche Führungsmagnetfelder (M1, M2) erzeugt werden, und wobei das Verfahren folgende Schritte umfasst:

- Erzeugung des ersten tunnelförmigen Führungsmagnetfeldes (M1), welches zur Führung des Brennflecks des Lichtbogens während einer ersten Laufzeit t1, auf einer ersten Laufbahn auf der zu verdampfenden Kathodenfläche verwendet wird, wobei ein erster Erosionsweg (W1) mit Länge (L1) in einem ersten Bereich der Kathodenfläche entsteht, wobei die erste Laufzeit (t1) der Zeit entspricht, welche der Brennfleck braucht, um einmal die komplette Länge (L1) des ersten Erosionswegs (W1) zu durchlaufen.

- Veränderung der Eigenschaften des ersten Führungsmagnetfeldes zur Einstellung eines zweiten tunnelförmigen, von dem ersten unterschiedlichen, Führungsmagnetfeldes (M2), welches zur Führung des Brennflecks des Lichtbogens während einer zweiten Laufzeit (t2), auf einer zweiten Laufbahn auf der zu verdampfenden Kathodenfläche verwendet wird, wobei ein zweiter Erosionsweg (W2) mit Länge (L2) in einem zweiten Bereich der Kathodenfläche entsteht, wobei die zweite Laufzeit (t2) der Zeit entspricht, welche der Brennfleck braucht, um einmal die komplette Länge (L2) des zweiten Erosionswegs (W2) durchzulaufen.

- Durchführung des Lichtbogenverdampfungsprozesses, wobei während der gesamten Dauer des Lichtbogenverdampfungsprozesses, $t_{Tot}$, das erste Führungsmagnetfeld (M1) während einer Einschaltzeit $t_{ein}1$ und das zweite Führungsmagnetfeld (M2) während einer Einschaltzeit $t_{ein}2$ eingesetzt werden, wobei $t_{ein}1 \geq t1$, $t_{ein}2 \geq t2$, und $t_{Tot}$

$\geq t_{ein}1 + t_{ein}2$ ist, und wobei t1 und t2 jeweils Sekunden bis Minuten dauern, und wobei die integrale Spotgeschwindigkeit in erster Nähe als konstant angenommen wird.

Die Eigenschaften des ersten tunnelförmigen Führungsmagnetfeldes können gemäss der vorliegenden Erfindung n-mals verändert werden, um eine Anzahl n von tunnelförmigen Führungsmagnetfeldern Mi einzustellen, wobei n eine ganze Zahl ist, $n \geq 2$, i eine ganze Zahl ist und i = 1 bis n, wobei für jedes tunnelförmige Führungsmagnetfeld eine unterschiedliche Laufbahn zur Führung des Brennflecks des Lichtbogens während einer zweiten Laufzeit ti resultiert und auf diese Weise ein unterschiedlicher Erosionsweg Wi mit entsprechenden Länge Li entsteht, wobei die Laufzeit ti der Zeit entspricht, welche der Brennfleck braucht, um jeweils einmal die komplette Länge Li des entsprechenden Erosionswegs Ei durchzulaufen, und wobei jeweils $t_{ein}i \leq ti$, ti Sekunden bis Minuten dauert, und wobei die gesamte Dauer des Lichtbogenverdampfungsprozesses $t_{Tot} = \Sigma ti$ von ti = 1 bis ti = n.

$t_{ein}1$, $t_{ein}2$ oder gegebenenfalls $t_{ein}i$ kann ein ganzzahliges Vielfaches eines gleichen Faktors $k \geq 1$ sein, wobei $t_{ein}1 = k*t1$, $t_{ein}2 = k*t2$ oder gegebenenfalls $t_{ein}i = k*ti$.

Vorzugsweise werden die Eigenschaften der tunnelförmigen Führungsmagnetfelder so ausgewählt, dass zumindest zwei Erosionswege kreisförmig sind.

Vorzugsweise sollen die zumindest zwei kreisförmigen Erosionswege in der Mitte der zu verdampfenden Kathodenfläche zentriert sein.

Vorzugsweise soll der Abstand zweier benachbarter kreisförmiger Erosionswege mindestens 1 mm, vorzugsweise 3 bis 10 mm aufweisen.

Vorzugsweise wird zur Erzeugung des inneren Magnetfelds und/oder zur Erzeugung des äußeren Magnetfels mindestens eine Spule verwendet und zur Einstellung der unterschiedlichen tunnelförmigen Führungsmagnetfelder der Strom, der durch die Spule durchfließt, verändert.

Gemäß einer bevorzugten Ausführungsform der vorliegenden Erfindung besteht die zu verdampfende Kathodenfläche aus einem Graphitmaterial oder aus einem mit anderen Elementen legiertem Graphitmaterial.

Vorzugsweise ist die oben erwähnte Spule eine äußere Spule (22), welche einen Eisenkern (24) aufweist.

Vorzugsweise ist die Kathode plattenförmig und weist eine kreisförmige zu verdampfende Fläche auf.

Vorzugsweise wird das innere Magnetfeld so erzeugt, dass es das Laufverhalten im Wesentlichen in die Mitte der Kathode konzentriert.

Vorzugsweise wird jedes Führungsmagnetfeld M1, M2 und gegebenenfalls Mi, jeweils während einer Einschaltzeit $t_{ein}1$, $t_{ein}2$ und gegebenenfalls $t_{ein}i$, sequenziell eingesetzt, dergestalt, dass ein homogenes Erodieren der zu verdampfenden Kathodenfläche erreicht wird.

Gemäß einer weiteren bevorzugten Ausführungsform der vorliegenden Erfindung ist $t_{ein}1$, $t_{ein}2$ und gegebenenfalls $t_{ein}i$ ein ganzzahliges Vielfaches eines eigenen, nicht unbedingt gleichen Faktors jeweils k1, k2, oder gegebenenfalls ki, wobei $t_{ein}1 = k1*t1$, $t_{ein}2 = k2*t2$ oder gegebenenfalls $t_{ein}i = ki*ti$.

Vorzugsweise sind alle Erosionswege Ei kreisförmig.

Vorzugsweise sind alle kreisförmigen Erosionswege Ei in der Mitte der zu verdampfenden Kathodenfläche zentriert.

**Patentansprüche**

1. Verfahren zur Verdampfung einer Kathode (30) mittels eines kathodischen Lichtbogenverdampfungsprozesses in einer Vakuumkammer (1), bei dem ein Lichtbogen gezündet wird und die Bewegung des Brennflecks des Lichtbogens auf einer vorbestimmten Laufbahn auf der zu verdampfenden Kathodenoberfläche mittels eines Führungsmagnetfeldes gezwungen wird, wobei innere Magnetmittel (10) innerhalb der Vakuumkammer (1) und äußere Magnetmittel (20) außerhalb der Vakuumkammer (1) zur Erzeugung mindestens jeweils eines inneren Magnetfeldes und eines äußeren Magnetfeldes verwendet werden, wobei das Führungsmagnetfeld ein tunnelförmiges Führungsmagnetfeld ist, welches durch die Wechselwirkung der Magnetfelder entsteht, **dadurch gekennzeichnet, dass** das tunnelförmige Führungsmagnetfeld veränderbar ist und während der Durchführung des Lichtbogenverdampfungsprozesses mindestens zwei unterschiedliche Führungsmagnetfelder (M1, M2) erzeugt werden, und wobei das Verfahren folgende Schritte umfasst:

   - Erzeugung des ersten tunnelförmigen Führungsmagnetfeldes (M1), welches zur Führung des Brennflecks des Lichtbogens während einer ersten Laufzeit t1, auf einer ersten Laufbahn auf der zu verdampfenden Kathodenfläche verwendet wird, wobei ein erster Erosionsweg (W1) mit Länge (L1) in einem ersten Bereich der Kathodenfläche entsteht, wobei die erste Laufzeit (t1) der Zeit entspricht, welche der Brennfleck braucht, um einmal die komplette Länge (L1) des ersten Erosionswegs (W1) zu durchlaufen.
   - Veränderung der Eigenschaften des ersten Führungsmagnetfeldes zur Einstellung eines zweiten tunnelförmigen, von dem ersten unterschiedlichen, Führungsmagnetfeldes (M2), welches zur Führung des Brennflecks des Lichtbogens während einer zweiten Laufzeit (t2), auf einer zweiten Laufbahn auf der zu verdampfenden Kathodenfläche verwendet wird, wobei ein zweiter Erosionsweg (W2) mit Länge (L2) in einem zweiten Bereich der Kathodenfläche entsteht, wobei die zweite Laufzeit (t2) der Zeit entspricht, welche der Brennfleck braucht, um einmal die komplette Länge (L2) des zweiten Erosionswegs (W2) durchzulaufen.
- Durchführung des Lichtbogenverdampfungsprozesses, wobei während der gesamten Dauer des Lichtbogenverdampfungsprozesses, $t_{Tot}$, das erste Führungsmagnetfeld (M1) während einer Einschaltzeit $t_{ein}1$ und das zweite Führungsmagnetfeld (M2) während einer Einschaltzeit $t_{ein}2$ eingesetzt werden, wobei $t_{ein}1 \geq t1$, $t_{ein}2 \geq t2$, und $t_{Tot} \geq t_{ein}1 + t_{ein}2$ ist, und wobei t1 und t2 jeweils Sekunden bis Minuten dauern, und wobei die integrale Spotgeschwindigkeit in erster Nähe als konstant angenommen wird.

2.  Verfahren nach Anspruch 1, wobei die Eigenschaften des ersten tunnelförmigen Führungsmagnetfeldes n-mals verändert werden, um eine Anzahl n von tunnelförmigen Führungsmagnetfeldern Mi einzustellen, wobei n eine ganze Zahl ist, n $\geq$ 2, i eine ganze Zahl ist und i = 1 bis n, wobei für jedes tunnelförmige Führungsmagnetfeld eine unterschiedliche Laufbahn zur Führung des Brennflecks des Lichtbogens während einer zweiten Laufzeit ti resultiert und auf diese Weise ein unterschiedlicher Erosionsweg Wi mit entsprechenden Länge Li entsteht, wobei die Laufzeit ti der Zeit entspricht, welche der Brennfleck braucht, um jeweils einmal die komplette Länge Li des entsprechenden Erosionswegs Ei durchzulaufen, und wobei jeweils $t_{ein}i \leq ti$, ti Sekunden bis Minuten dauert, und wobei die gesamte Dauer des Lichtbogenverdampfungsprozesses $t_{Tot} = \Sigma ti$ von ti = 1 bis ti = n.

3.  Verfahren nach Anspruch 1 oder 2, wobei $t_{ein}1$, $t_{ein}2$ oder gegebenenfalls $t_{ein}i$ ein ganzzahliges Vielfaches eines gleichen Faktors k $\geq$ 1 ist, wobei $t_{ein}1 = k*t1$, $t_{ein}2 = k*t2$ oder gegebenenfalls $t_{ein}i = k*ti$.

4.  Verfahren nach einem der vorangehenden Ansprüche, wobei zumindest zwei Erosionswege kreisförmig sind.

5.  Verfahren nach Anspruch 4, wobei die zumindest zwei kreisförmigen Erosionswege in der Mitte der zu verdampfenden Kathodenfläche zentriert sind.

6.  Verfahren nach Anspruch 5, wobei der Abstand zweier benachbarter kreisförmiger Erosionswege mindestens 1 mm, vorzugsweise 3 bis 10 mm, aufweist.

7.  Verfahren nach einem der vorangehenden Ansprüche, wobei zur Erzeugung des inneren Magnetfelds und/oder zur Erzeugung des äußeren Magnetfels mindestens eine Spule verwendet wird und zur Einstellung der unterschiedlichen tunnelförmigen Führungsmagnetfelder der Strom, der durch die Spule durchfließt, verändert wird.

8.  Verfahren nach einem der vorangehenden Ansprüche, wobei die zu verdampfende Kathodenfläche aus einem Graphitmaterial oder aus einem mit anderen Elementen legiertem Graphitmaterial besteht.

9.  Verfahren nach Anspruch 7 oder 8, wobei die Spule eine äußere Spule (22) ist, welche einen Eisenkern (24) aufweist.

10. Verfahren nach einem der vorangehenden Ansprüche, wobei die Kathode (30) plattenförmig ist und eine kreisförmige zu verdampfende Fläche aufweist.

11. Verfahren nach einem der vorangehenden Ansprüche, wobei das innere Magnetfeld so erzeugt wird, dass es das Laufverhalten im Wesentlichen in die Mitte der Kathode konzentriert.

12. Verfahren nach einem der vorangehenden Ansprüche, wobei jedes Führungsmagnetfeld M1, M2 und gegebenenfalls Mi, jeweils während einer Einschaltzeit $t_{ein}1$, $t_{ein}2$ und gegebenenfalls $t_{ein}i$, sequenziell eingesetzt wird, dergestalt, dass ein homogenes Erodieren der zu verdampfenden Kathodenfläche erreicht wird.

13. Verfahren nach Anspruch 1 oder 2, wobei $t_{ein}1$, $t_{ein}2$ und gegebenenfalls $t_{ein}i$ ein ganzzahliges Vielfaches eines eigenen, nicht unbedingt gleichen Faktors jeweils k1, k2, oder gegebenenfalls ki ist, wobei $t_{ein}1 = k1*t1$, $t_{ein}2 = k2*t2$ oder gegebenenfalls $t_{ein}i = ki*ti$.

14. Verfahren nach einem der vorangehenden Ansprüche, wobei alle Erosionswege Ei kreisförmig sind.

15. Verfahren nach Anspruch 14, wobei alle Erosionswege Ei in der Mitte der zu verdampfenden Kathodenfläche zentriert sind.

**Claims**

1. A method for the evaporation of a cathode (30) by means of a cathodic arc evaporation process in a vacuum chamber (1) in which an arc is ignited and the movement of the focal spot of the arc is forced on a predetermined track on the cathode surface to be evaporated by means of a guiding magnetic field, wherein inner magnetic means (10) inside the vacuum chamber (1) and outer magnetic means (20) outside the vacuum chamber (1) are used to produce at least one inner magnetic field and one outer magnetic field, wherein the guiding magnetic field is a tunnel-shaped guiding magnetic field, which is produced by the interaction of the magnetic fields, **characterized in that** the tunnel-shaped guiding magnetic field can be changed and during the execution of the arc evaporation process, at least two different guiding magnetic fields (M1, M2) are produced and wherein the method comprises the following steps:

   - Production of the first tunnel-shaped guiding magnetic field (M1), which is used during a first run-time t1 to guide the focal spot of the arc on a first track on the cathode surface that is to be evaporated, wherein a first erosion path (W1) with a length (L1) is produced in a first region of the cathode surface, wherein the first run-time (t1) corresponds to the time that the focal spot needs to travel the complete length (L1) of the first erosion path (W1) one time.
   - Alteration of the properties of the first guiding magnetic field in order to adjust a second tunnel-shaped guiding magnetic field (M2) that is different from the first and that is used during a second run-time (t2) to guide the focal spot of the arc on a second track on the cathode surface that is to be evaporated, wherein a second erosion path (W2) with a length (L2) is produced in a second region of the cathode surface, wherein the second run-time (t2) corresponds to the time that the focal spot needs to travel the complete length (L2) of the second erosion path (W2) one time.
   - Execution of the cathodic arc evaporation process, wherein during the total duration of the cathodic arc evaporation process $t_{Tot}$, the first guiding magnetic field (M1) is applied during a switch-on time $t_{on}1$ and the second guiding magnetic field (M2) is applied during a switch-on time $t_{on}2$, wherein $t_{on}1 \geq t1$, $t_{on}2 \geq t2$, and $t_{Tot} \geq t_{on}1 + t_{on}2$, and wherein t1 and t2 last from seconds to minutes, and wherein the integral spot speed in the immediate vicinity is assumed to be constant.

2. The method according to claim 1, wherein the properties of the first tunnel-shaped guiding magnetic field can be changed n times in order to adjust a number n of tunnel-shaped guiding magnetic fields Mi, wherein n is a whole number, $n \geq 2$, i is a whole number, and i = 1 to n, wherein each tunnel-shaped guiding magnetic field results in a different track for the guidance of the focal spot of the arc during a second run-time ti and in this way, a different erosion path Wi with a corresponding length Li is produced, wherein the run-time ti corresponds to the time that the focal spot needs to travel the complete length Li of the corresponding erosion path Ei once, and wherein each $t_{on}i \leq ti$, ti lasts from seconds to minutes, and wherein the entire duration of the arc evaporation process $t_{Tot} = \Sigma ti$ from ti=1 to ti=n.

3. The method of claim 1 or 2, wherein $t_{on}1$, $t_{on}2$, or possibly $t_{on}i$ is an integral multiple of the same factor $k \geq 1$, wherein $t_{on}1 = k*t1$, $t_{on}2 = k*t2$, or possibly $t_{on}i = k*ti$.

4. The method according to one of the preceding claims, wherein at least two erosion paths are circular.

5. The method of claim 4, wherein the at least two circular erosion paths are centered in the middle of the cathode surface that is to be evaporated.

6. The method of claim 5, wherein the distance between two adjacent circular erosion paths is at least 1 mm, preferably 3 to 10 mm.

7. The method according to one of the preceding claims, wherein, in order to produce the inner magnetic field and/or to produce the outer magnetic field, at least one coil is used and to adjust the different tunnel-shaped guiding magnetic fields, the current that flows through the coil is changed.

8. The method according to one of the preceding claims, wherein the cathode surface that is to be evaporated is composed of a graphite material or a graphite material that is alloyed with other elements.

9. The method of claim 7 or 8, wherein the coil is an outer coil (22), which has an iron core (24).

10. The method according to one of the preceding claims, wherein the cathode (30) is plate-shaped and has a circular surface that is to be evaporated.

11. The method according to one of the preceding claims, wherein the inner magnetic field is produced in such a way that the travel behavior is concentrated essentially in the middle of the cathode.

12. The method according to one of the preceding claims, wherein each guiding magnetic field M1, M2, and possibly Mi, respectively during a switch-on time $t_{on}1$, $t_{on}2$, and possibly $t_{on}i$, is applied sequentially in such a way that a homogeneous erosion of the cathode surface to be evaporated is achieved.

13. The method of claim 1 or 2, wherein $t_{on}1$, $t_{on}2$, and possibly $t_{on}i$ is an integral multiple of a separate, not necessarily equal, factor of k1, k2, or possibly ki, respectively, wherein $t_{on}1=k1*t1$, $t_{on}2=k2*t2$, or possibly $t_{on}i=ki*ti$.

14. The method according to one of the preceding claims, wherein all of the erosion paths Ei are circular.

15. The method of claim 14, wherein all of the erosion paths Ei are centered in the middle of the cathode surface to be evaporated.

**Revendications**

1. Procédé d'évaporation d'une cathode (30) au moyen d'un processus d'évaporation par arc cathodique dans une chambre à vide (1), dans lequel un arc est allumé et le mouvement de la tache focale de l'arc est forcé sur une trajectoire prédéterminée de la surface de la cathode à évaporer au moyen d'un champ magnétique de guidage, des moyens magnétiques (10) internes à l'intérieur de la chambre à vide (1) et des moyens magnétiques externes (20) à l'extérieur de la chambre à vide (1) étant utilisés pour produire au moins un champ magnétique interne et un champ magnétique externe, le champ magnétique de guidage étant un champ magnétique de guidage en forme de tunnel, qui est produit par l'interaction des champs magnétiques, **caractérisé en ce que** le champ magnétique de guidage en forme de tunnel peut être modifié et pendant l'exécution du processus d'évaporation par arc cathodique, au moins deux champs magnétiques de guidage différents (M1, M2) sont produits et le procédé comprenant les étapes suivantes :

- la production du premier champ magnétique de guidage en forme de tunnel (M1), qui est utilisé pendant une première période t1 pour guider la tache focale de l'arc sur une première trajectoire sur la surface de la cathode qui doit être évaporée, un premier chemin d'érosion (W1) avec une longueur (L1) étant produit dans une première région de la surface de la cathode, la première période (t1) correspondant au temps nécessaire à la tache focale pour parcourir la longueur complète (L1) du premier chemin d'érosion (W1) une fois.
- La modification des propriétés du premier champ magnétique de guidage afin d'ajuster un deuxième champ magnétique de guidage en forme de tunnel (M2) qui est différent du premier et utilisé pendant une deuxième période (t2) sur une deuxième trajectoire sur la surface de la cathode à évaporer pour guider la tache focale de l'arc, un deuxième chemin d'érosion (W2) avec une longueur (L2) étant produit dans une deuxième région de la surface de la cathode, et la deuxième période (t2) correspondant au temps nécessaire à la tache focale pour parcourir la longueur complète (L2) du deuxième chemin d'érosion (W2) une fois.
- l'exécution du processus d'évaporation par arc cathodique, dans lequel pendant la durée totale du processus d'évaporation par arc cathodique $t_{Tot}$, le premier champ magnétique de guidage (M1) est utilisé pendant une durée d'activation $t_{act}1$ et le second champ magnétique de guidage (M2) est utilisé pendant une durée d'activation $t_{act}2$, où $t_{act}1 \geq t1$, $t_{act}2 \geq t2$ et $t_{Tot} \geq t_{act}1+t_{act}2$, et t1 et t2 durant de quelques secondes à quelques minutes, et la vitesse de spot intégrale est supposée constante dans le voisinage immédiat.

2. La méthode selon la revendication 1, dans laquelle les propriétés du premier champ magnétique de guidage en forme de tunnel peuvent être modifiées n fois afin d'ajuster un nombre n de champs magnétiques de guidage Mi en forme de tunnel, où n est un nombre entier, $n \geq 2$, i est un nombre entier, et i = 1 à n, chaque champ magnétique de guidage en forme de tunnel entraînant une trajectoire différente pour le guidage de la tache focale de l'arc pendant une deuxième période ti et de cette manière, un chemin d'érosion différent Wi avec une longueur correspondante Li est produit, la période ti correspondant au temps nécessaire à la tache focale pour parcourir une fois la longueur complète Li du chemin d'érosion correspondant Ei, et dans chaque cas $t_{act}i \leq ti$, ti durant de quelques secondes à quelques minutes, et la durée totale du processus d'évaporation de l'arc cathodique $t_{tot}=\Sigma ti$ de ti = 1 à ti = n.

3. La méthode selon l'une des revendications 1 ou 2, dans laquelle $t_{act}1$, $t_{act}2$, ou éventuellement $t_{act}i$ est un multiple entier d'un même facteur k $\geq$ 1, où $t_{act}1=k*t1$, $t_{act}2=k*t2$, ou éventuellement $t_{act}i=k*ti$.

4. La méthode selon l'une des revendications précédentes, dans laquelle au moins deux chemins d'érosion sont circulaires.

5. La méthode selon la revendication 4, dans laquelle les au moins deux chemins d'érosion circulaires sont centrés au milieu de la surface de la cathode qui doit être évaporée.

6. La méthode selon la revendication 5, dans laquelle la distance entre deux chemins d'érosion circulaires adjacents est d'au moins 1 mm, de préférence de 3 à 10 mm.

7. La méthode selon l'une des revendications précédentes, dans laquelle au moins une bobine est utilisée pour produire le champ magnétique interne et/ou pour produire le champ magnétique externe, et le courant qui traverse la bobine est modifié pour ajuster les différents champs magnétiques de guidage en forme de tunnel.

8. La méthode selon l'une des revendications précédentes, dans laquelle la surface de la cathode qui doit être évaporée se compose d'un matériau graphite ou d'un matériau graphite qui est allié à d'autres éléments.

9. La méthode selon l'une des revendications 7 ou 8, dans laquelle la bobine est une bobine externe (22), qui a un noyau de fer (24).

10. La méthode selon l'une des revendications précédentes, dans laquelle la cathode (30) est en forme de plaque et a une surface circulaire à évaporer.

11. La méthode selon l'une des revendications précédentes, dans laquelle le champ magnétique interne est produit de sorte que le comportement de déplacement est concentré essentiellement au milieu de la cathode.

12. La méthode selon l'une des revendications précédentes, dans laquelle chaque champ magnétique de guidage M1, M2 et éventuellement Mi, est utilisé séquentiellement pendant une durée d'activation $t_{act}1$, $t_{act}2$ et éventuellement $t_{act}i$, de manière à obtenir une érosion homogène de la surface cathodique à évaporer.

13. La méthode selon l'une des revendications 1 ou 2, dans laquelle $t_{act}1$, $t_{act}2$ et éventuellement $t_{act}i$ sont un multiple entier d'un facteur séparé k1, k2 ou éventuellement ki, ledit facteur n'étant pas nécessairement égal et $t_{act}1=k*t1$, $t_{act}2=k*t2$, ou éventuellement $t_{act}i=k*ti$.

14. La méthode selon l'une des revendications précédentes, dans laquelle tous les chemins d'érosion Ei sont circulaires.

15. La méthode selon la revendication 14, dans laquelle tous les chemins d'érosion Ei sont centrés au milieu de la surface cathodique à évaporer.

Abbildung 1

Abbildung 2

Abbildung 3

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- DE 4008850 A1
- EP 1382711 A1
- WO 8901699 A1
- EP 0508612 A2
- EP 2140476 B1

### In der Beschreibung aufgeführte Nicht-Patentliteratur

- **KANDAH et al.** Vaccum arc cathode spot movement on various kinds of graphite cathodes. *Plasma Sources Sci. Technol.,* 1996, vol. 5, 349-355
- **LIUHE LI et al.** Control of cathodic arc spot motion under external magnetic field. *Vacuum,* 2013, vol. 91, 20-23
- **AKSENOV et al.** Magnetic Field influence on the shape of eroding surface of graphite cathodes. *Problems of Atomic Science and Technology. 2002. Nr. 5 Series: Plasma Physics,* vol. 8, 142-144